# EUROPEAN PATENT SPECIFICATION

(11) **EP 1 522 098 B1**
(45) Date of publication and mention of the grant of the patent: **21.04.2010**
(21) Application number: 03794837.9
(22) Date of filing: 16.07.2003
(51) Int. Cl.: H01L 21/762

(54) **A METHOD OF INCREASING THE AREA OF A USEFUL LAYER OF MATERIAL TRANSFERRED ONTO A SUPPORT**
VERFAHREN ZUR VERGRÖSSERUNG DER FLÄCHE EINER NUTZSCHICHT EINES AUF EINE STÜTZE ÜBERTRAGENEN MATERIALS
PROCEDE PERMETTANT D'AUGMENTER LA SURFACE D'UNE COUCHE UTILE D'UN MATERIAU APRES TRANSFERT SUR UN SUPPORT

(30) Priority: 17.07.2002 FR 0209020; 27.05.2003 US 473137 P
(43) Date of publication of application: 13.04.2005
(73) Proprietor: S.O.I.TEC Silicon on Insulator Technologies S.A., 38190 Bernin (FR)
(72) Inventor: MALEVILLE, Christophe, F-38660 La Terrasse (FR)
(74) Representative: Bomer, Françoise Marie
(86) International application number: PCT/EP2003/007856
(87) International publication number: WO 2004/025722

(56) References cited:
- EP-A- 0 451 993
- EP-A- 1 059 663
- EP-A- 1 189 266
- US-A1- 2001 055 854
- PATENT ABSTRACTS OF JAPAN vol. 018, no. 290 (E-1557), 2 June 1994 (1994-06-02) -& JP 06 061201 A (SHIN ETSU HANDOTAI CO LTD), 4 March 1994 (1994-03-04)

## Description

The present invention relates to a method of increasing the area of a useful layer of semiconductor material which is effectively transferred onto a support during the fabrication of substrates, in particular for electronics, optics, or optoelectronics.

Currently, all substrates fabricated using techniques combining bonding by molecular bonding (known as "wafer bonding") and transferring a useful layer onto a support have a zone known as a "peripheral ring".

Said ring is a zone located at the periphery of the support and for which transfer of the useful layer has not occurred, or when transfer has occurred, said ring is a zone in which the useful layer has been transferred partially, or has disappeared during subsequent treatment, due to its poor bonding to said support.

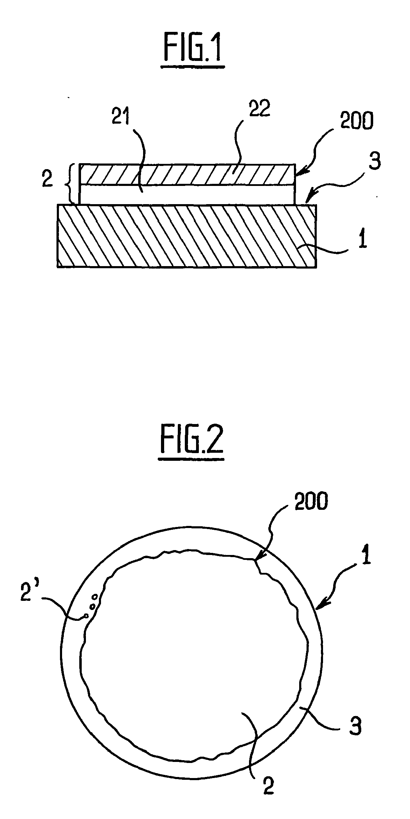

Accompanying Figures 1 and 2 are respective cross sectional and plan views of a substrate that is known to the skilled person under the acronym "SOI" meaning "silicon on insulator".

Figure 1 shows a support 1 of silicon onto which a composite layer 2 comprising a layer of silicon oxide 21 surmounted by a layer of silicon 22 has been transferred by molecular bonding.

The term "ring" 3 defines a substantially annular zone of support 1 onto which the composite layer 2 has either not been transferred or has been transferred poorly during transfer of the layer.

More precisely, in the plan view of Figure 2, it can be seen that this ring 3 is of varying width and/or shape, i.e. that the vertical side 200 of the composite layer 2 can be irregular (jagged) and/or that islands 2' of composite layer may exist that have been transferred onto the support 1, but that are spaced apart from the remainder of the central portion of said composite layer 2.

It should be noted that Figures 1 and 2 are diagrams that are not to scale both as regards the thickness of the different layers and of the support and as regards the width of the ring.

Said ring phenomenon occurs with other substrates, for example those known under the acronym "SICOI" meaning "silicon carbide on insulator" or under the acronym "SOQ" meaning "silicon on quartz". Other multi-layer substrates such as those comprising gallium arsenide on silicon (AsGa/Si) also exhibit said ring.

Independently of the diameter of support 1, which can vary, for example, from 2 inches (50 millimeters (mm)) for silicon carbide to 12 inches (300 mm) for certain silicon substrates, said ring 3 generally varies from 1 mm to 4 mm in width, plus-or-minus 0.5 mm. Further, said width can fluctuate, i.e., it can be smaller on one side of the substrate than on the other.

The appearance of said ring during layer transfer has a variety of origins, as discussed below. Particular mention can be made of the existence of chamfers on the substrates used, variations in bonding energy, and finally certain aggressive steps in substrate fabrication methods.

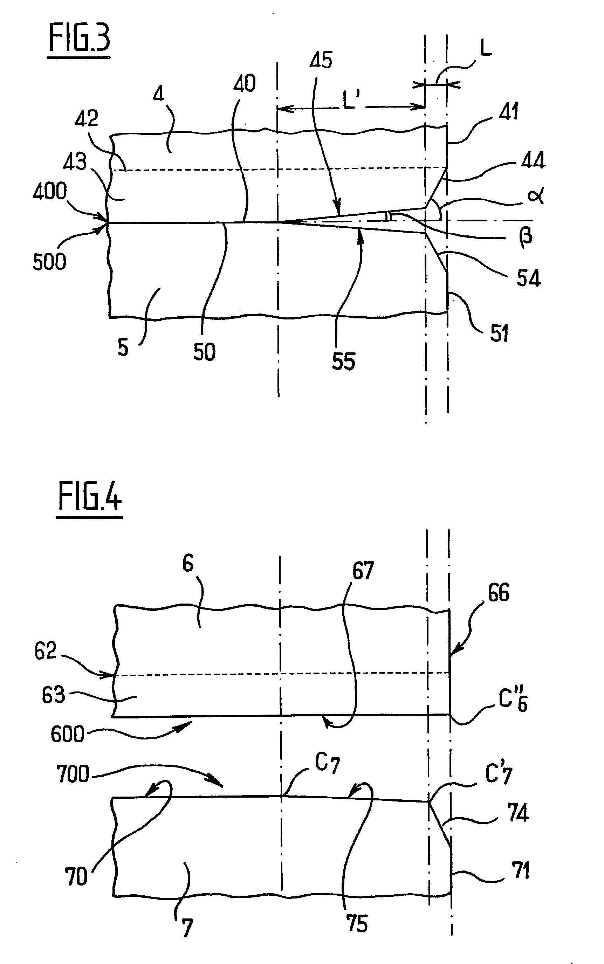

In order to explain the appearance of said ring, reference is made to the accompanying Figure 3 which is a diagrammatic cross section of a portion of the sides of two substrates bonded together by molecular bonding, namely a source substrate 4 from which the future useful layer is to be cut, and a support substrate 5 intended to receive said useful layer. This figure illustrates the prior art.

In the remainder of the description and drawings, the substrates are assumed to be circular in shape as this is the shape encountered most frequently. However, they can have other shapes.

The source substrate 4 has two opposite faces that are parallel; in Figure 3 reference numeral 400 designates a "front" one of said faces. Said front face 400 is intended for bonding onto said support 5. The source substrate 4 has a side 41.

Further, the substrate 4 has undergone treatment that forms a zone of weakness 42 that defines two portions, a rear portion and a useful layer 43 intended for subsequent transfer to the support 5.

Throughout the remainder of the description and claims, the expression "useful layer" designates a transferred layer of thickness that depends on whether it is obtained, for example, by a method of implanting atomic species or by abrasive polishing and/or chemical etching as is described below.

Currently, the substrates used both as the source substrate and as the support substrate are commercially available substrates satisfying standardized requirements (for example SEMI M1-0302 standards for a silicon substrate). Those standards are mainly concerned with ensuring said substrates can be accepted by the equipment of as wide a range of users as possible.

According to those standards, at the intersection between the side 41 and the front face 400, the substrate 4 has an annular primary chamfer 44 or primary drop making a large angle α (close to 45°) with the plane of said front face 400 and more precisely with the rigorously flat central zone 40, as will be explained below. Said primary chamfer 44 extends over a width L in the radial direction. Said width L varies from 100 micrometers (µm) to 500 µm depending on the different substrates. Said primary chamfer 44 is intended to limit the risk of mechanical rupture and notching of the source substrate 4.

In a similar manner to that just described for the source substrate 4, the support substrate 5 has a front face 500, a side 51 and a primary chamfer 54.

When substrates 4 and 5 are bonded to each other, bonding does not occur at chamfers 44 and 54 because of the magnitude of angle α. The width of the ring can thus be expected to correspond to the width L of said primary chamfers 44 and 54. It has been shown, however, that it is even wider in practice.

It has been observed that the front face 400 of substrate 4 actually has two zones, namely a first flat zone 40 located substantially at the center of said substrate 4 and hereinafter termed the "flat central zone" and a second zone 45 surrounding the first zone.

The second zone 45 is a secondary chamfer that is generally annular or a secondary drop forming an angle β with the plane of the flat central zone 40. Said secondary chamfer 45 extends between said flat zone 40 and the primary chamfer 44.

Throughout the remainder of the description and claims, the expression "flat" means a flatness that is suitable for bonding, and the expression "central zone" designates a zone located substantially at the center of the front face of the substrate but which can, however, be located slightly excentrically on said face.

It should be noted that Figure 3 and the following figures are only diagrammatic in nature and the magnitude of angle β has been considerably exaggerated in the figures for clarification purposes.

More precisely, the secondary chamfer 45 constitutes a drop that is less sharp than the primary chamfer 44 and which appears during the various substrate shaping steps (lapping, polishing, chemical etching), these steps producing an etching and material-removal effect that is greater on the substrate side. Said secondary chamfer 45 is not subject to standards. Its width **L'** taken in a radial direction varies from about 500 µm to 3000 µm on substrates that are commercially available on the market. Said secondary chamfer 45 is a poorly defined zone of dimensions that are not defined by the above-mentioned standards. Further, the value of angle β also fluctuates, and so secondary chamfer 45 is not flat as shown diagrammatically in Figure 3 but can be domed or irregular in places.

As a result, in reality (and in contrast to the diagrammatic representation of the figures), the side of the source substrate 4 is not formed by a plurality of beveled slopes but has a somewhat convex shape, i.e., without edges between the secondary chamfer 45 and the primary chamfer 44 or between the primary chamfer and the side 41. The purpose of the convex shape is to avoid any nicking of the substrate 4.

In a manner similar to that just described for the source substrate 4, the support substrate 5 has a flat central zone 50 and a substantially annular secondary chamfer 55, but has the same irregularities as the secondary chamfer 45.

Molecular bonding is a technique that cannot tolerate non-planar surfaces and the existence of said secondary chamfers 45, 55 results in poor bonding and layer transfer in that zone, resulting in the appearance of a peripheral ring.

In addition, a second reason for the appearance of said ring is that the bonding energy between two facing substrate faces fluctuates as a function of parameters such as roughness, flatness and the chemical nature of the surfaces in contact, the presence of particles, etc. Said parameters can also vary in a less controlled manner at the sides of the substrates, thereby also explaining the formation of the ring.

Finally, another possible cause for formation of the ring is the use of certain aggressive steps during the substrate fabrication methods.

Methods of fabricating substrates known under the acronym BESOI (bond and etchback silicon on insulator) bond a source substrate onto a support substrate, at least one of the faces of the source substrate being coated with a layer of oxide. The exposed surface of the source substrate then undergoes an abrasive polishing and/or chemical attack etching treatment followed by polishing until said source substrate becomes a useful layer.

In that type of method involving chemical attack (with the risk of partial delamination of the bonding interface), oxidation affecting the lateral and frontal portions of the source substrate, and mechanical abrasive polishing forces, both tend to enlarge the ring.

Similarly, in methods involving detachment of the layer by fracture along a zone of weakness, it has been observed that around the sides, detachment tends to occur at the bonding interface and not at the zone of weakness, resulting in the formation of an annular ring with a large surface area.

Referring again to Figure 3, in the particular case of the zone of weakness 42 being formed by hydrogen implantation, it has been shown that, during subsequent treatment to detach the useful layer 43 from the remainder of the source substrate 4, expansion of hydrogen bubbles exerts a substantially perpendicular force on the plane of the secondary chamfer 45. In that zone, said force is not compensated by sufficiently strong bonding, since the secondary chamfer 55 is spaced from the secondary chamfer 45 by an angle 2β and the bonding is thus ruptured. Thus, bubbles are formed at the surface of the secondary chamfer 45 instead of the layer 43 being transferred onto the support substrate 5. In other words, bonding occurs but its quality is bad.

A number of disadvantages are associated with the existence of said ring.

Firstly, it presents an unusable surface on which it is not possible to fabricate electronic components. Unfortunately, from an economic point of view, each extra square millimeter of area can make it possible to fabricate a larger number of components per substrate.

Furthermore, this ring is irregular as explained above, and its width can vary from one side to the other of the substrate, thus giving rise to problems of reproducibility in the various steps of an industrial process when such a substrate is used in a production facility.

The prior art includes methods of polishing the side of a substrate so as to make it possible to eliminate said ring, see for example document US 6 221 774.

A method of mechanically polishing sides is also known as used by the supplier SEZ. That method is used on solid silicon substrates after deposition operations which are known to run the risk of being associated with the effects of material being removed from the sides (known as "lift-off" or "peel-off"), i.e. leading to a high level of particulate contamination.

Nevertheless, those methods tend to increase the size of the zone having no transferred layer at the periphery, thereby restricting the useful area. In addition, finishing operations on the ring can lead to defects at the periphery of the transferred layer.

The document EP-1 059 663 describes a process for producing a semiconductor thin film comprising the steps of forming a semiconductor layer and a porous layer on a first substrate, removing said semiconductor layer at its peripheral region and separating the semiconductor layer from the first substrate by using a second substrate bonded to the surface of the semiconductor layer.

This process aims to solve a splitting problem related to the fact that the transferred layer has been epitaxially grown on the porous layer.

This document has not as object to improve the bonding between two substrates in order to increase the area of a useful layer transferred onto a support substrate.

To the contrary, the removing of the peripheral region of the semiconductor layer conducts to a restriction of the area of the useful layer transferred.

EP-0 451 993 describes a process beveling a front-side of a base wafer so that the bonding surface of the base wafer is made equal in size to the bonding surface of the bonding wafer.

An object of the present invention is thus to remedy the above-mentioned drawbacks, and in particular to reduce the area of said ring by increasing the quantity of material taken from the source substrate that is transferred onto a support during a layer transfer process.

The invention provides a method as recited in claim 1.

To this end, the invention provides a method of increasing the area of a useful layer of a material, in particular a semiconductor material, transferred onto a support substrate, during the fabrication of a composite substrate in particular for electronics, optics, or optoelectronics, the method comprising at least one step of molecular bonding a "front" face of a source substrate to a facing "front" face of a support substrate, and a step of transferring a useful layer coming from said source substrate onto said support substrate, said useful layer extending inside said source substrate from its front face.

According to the invention, before said bonding step, one of said support and source substrates, referred to as the "first" substrate is surrounded by a primary chamfer, its front face presenting a flat central zone, in that the other substrate, referred to as the "second" substrate, is a bulk substrate the front face of which presents a flat zone bordered by a peripheral side face, perpendicular or quasi-perpendicular thereto, the outer outline of said flat zone presenting dimensions greater than the dimensions of the outer outline of the flat central zone of the first substrate, and during bonding, the substrates are applied one against the other in such a manner that the outline of the flat central zone of the first substrate is inscribed within the outline of the flat zone of the second substrate.

By means of these characteristics of the invention, the useful layer is transferred over an area that is larger.

According to other advantageous and non-limiting characteristics of the invention, taken singly or in combination:
· the dimensions of the outer outline of the flat zone of the second substrate are greater than the dimensions of the inner outline of the primary chamfer of the first substrate, and during bonding, the substrates are applied one against the other in such a manner that the inner outline of the primary chamfer of the first substrate is inscribed inside the outer outline of the flat zone of the second substrate;
· the front face of the first substrate comprises a secondary chamfer extending between the flat central zone ant the primary chamfer;
· the first substrate is bonded to the second substrate in such a manner that its flat central zone is centered relative to the flat zone of said second substrate;
· the second substrate is the source substrate;
· prior to the step of bonding the source substrate and the support substrate against each other, the method consists in forming a zone of weakness inside said source substrate, said useful layer to be transferred extending between said zone of weakness and the front face of said substrate, and after the bonding step, the method consists in detaching said useful layer from the remainder of the source substrate along said zone of weakness;
· said zone of weakness is formed by implanting atomic species or is formed by a porous layer;
· the useful layer is detached by at least one of the following techniques taken alone or in combination: applying stresses of mechanical or electrical origin; supplying thermal energy, and chemical etching;
· at least one of the faces of the front face of the source substrate and the front face of the support substrate is coated in a layer of an insulating material.

Other characteristics and advantages of the invention become apparent from the following description of several preferred implementations of the invention. This description is made with reference to the accompanying drawings in which:
· Figure 1 is a diagram showing a vertical diametrical section through an SOI type substrate;
· Figure 2 is a diagram showing a plan view of the substrate of Figure 1;
· Figure 3 is a diagram showing a fragmentary vertical section of a source substrate and a support substrate bonded together using a prior art technique;
· Figure 4 is a fragmentary diagram in vertical section showing a source substrate and a support substrate in a first implementation of the method of the invention, said substrates being shown ready for being bonded together;
· Figures 5 and 6 are fragmentary diagrams in vertical section showing a source substrate and a support substrate respectively in a first implementation of Figure 4 and in a second implementation, said substrates being shown bonded together; and
· Figure 7 is a view from above of an angular portion of a support used in the method of the invention.

The aim of the invention is to improve the above-described method of fabricating a composite substrate, such a method including at least one step of molecular bonding one of the faces of a source substrate to a facing face of a support substrate, and a step of transferring a useful layer from said source substrate onto said support substrate.

Said composite substrates thus comprise at least one useful layer transferred onto a support.

With reference now to Figure 4, there can be seen a first implementation of the invention in which a source substrate 6 (from which a useful layer 63 is to be taken subsequently) is ready for being molecularly bonded to a support substrate 7.

In this implementation, the support substrate 7 is identical to the support substrate 5 described above and shown in Figure 3. It is therefore not described again in detail.

The support substrate 7 presents a side 71, a primary chamfer 74, and a front face 700 for receiving the front face 600 of the source substrate 6. This front face 700 covers both a flat central zone 70 and a secondary chamfer 75.

As shown in Figure 4 and in the subsequent figures, and as is usually the case, the source and support substrates 6 and 7 are circular. Similarly, their flat central zones are likewise circular, and the primary and secondary chamfers (when they exist) are described as being annular. Nevertheless, the substrates 6 and 7 and/or their respective central zones could be of other shapes, for example they could be oval, octagonal, or rectangular.

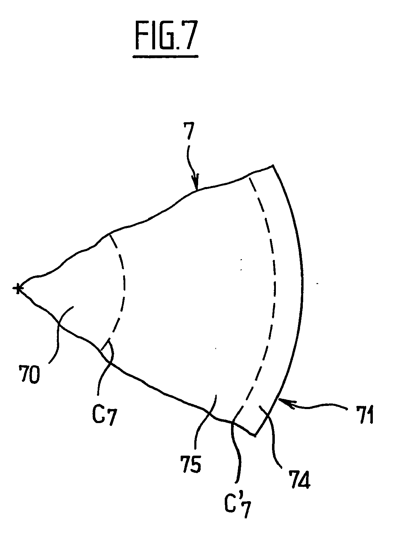

As can be seen more clearly in Figure 7, the secondary chamfer 75 is defined by an inner outline **C₇** and by an outer outline **C'₇.** It should be observed that the inner outline **C₇** of the secondary chamfer 75 constitutes the outer outline of the flat central zone 70, and similarly, the outer outline **C'₇** of the secondary chamfer 75 constitutes the inner outline of the primary chamfer 74.

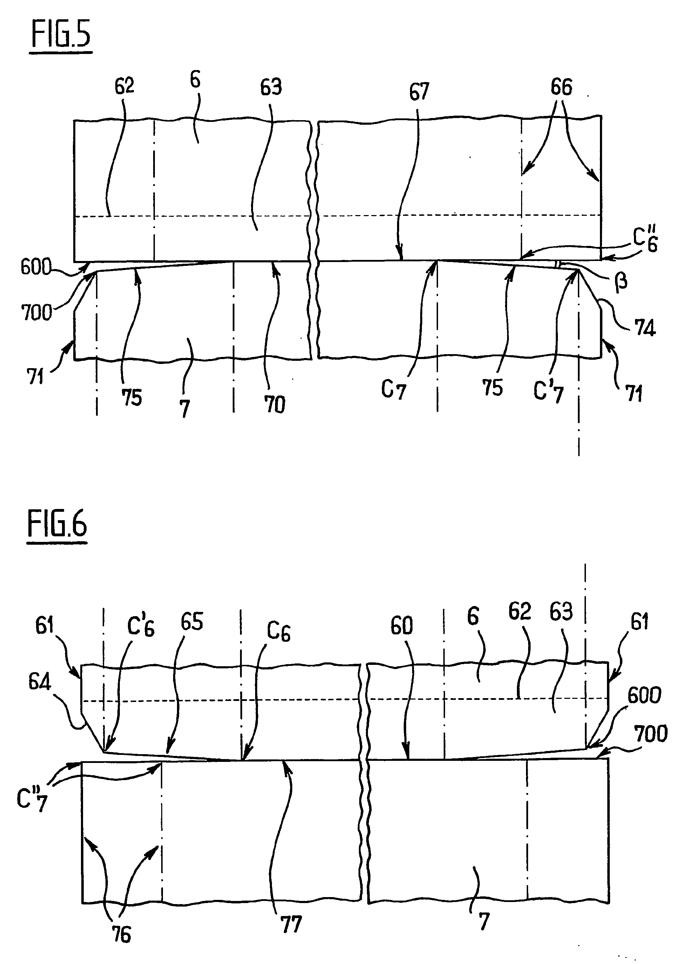

In a first implementation of the invention, shown in Figures 4 and 5, the substrate 6 is a bulk substrate, i.e the front face 600 of the source substrate 6 is not machined prior to the bonding step, so that compared with conventional substrates, it presents neither a primary chamfer nor a secondary chamfer. Consequently, the entire front face 600 is constituted by a flat zone given reference 67, which zone is surrounded by a side face 66.

In other words, the outline referenced C"₆ of said flat zone 67 constitutes the outer outline of the source substrate 6, and the peripheral side face 66 is perpendicular or quasi-perpendicular to said flat zone 67.

The term "quasi-perpendicular" means that by construction this side face 66 is perpendicular to the zone 67, even if certain subsequent polishing treatments might sometimes modify the angle very slightly.

Figure 5 shows three variants of the first embodiment of the invention.

In a first variant (shown in continuous lines), when the source substrate 6 is bonded to the support 7, the side face 66 of the source substrate 6 is situated vertically in register with the side face 71 of the support 7, and the two substrates 6 and 7 have the same dimensions (or the same diameter when the substrates are circular). This variant is advantageous in that it enables existing substrate-handling equipment to be used, since the diameter of the source substrate 6 as measured across its side face 66 is unchanged relative to the substrates presently in use in this type of method involving layer transfer and molecular bonding.

In a second variant (shown in chain-dotted lines), the side face 66 of the source substrate 6 is situated vertically in register with the secondary chamfer 75 (between the outlines **C₇** and **C'₇**).

In a third variant (not shown in the figure), the diameter of the source substrate 6 is greater than the diameter of the support 7, and the outline **C"₆** of the flat zone 67 then extends beyond the outside dimensions of the support 7.

In the above-mentioned variants, care is taken, in accordance with the invention, to ensure that the dimensions of the outline **C"₆** of the flat zone 67 of the source substrate 6 are greater than the dimensions of the outer outline **C₇** of the flat central zone 70 of the support substrate 7, and during bonding, the source substrate 6 is applied against the support substrate 7 in such a manner that the outline **C₇** is inscribed within the outline **C"₆.**

Also preferably, the dimensions of the outline **C"₆** of the flat central zone 67 of the source substrate 6 are greater than the dimensions of the inner outline **C'₇** of the primary chamfer 74 of the support 7, and during bonding, the source substrate 6 is applied against the support substrate 7 in such a manner that the inner outline **C'₇** is inscribed inside the outline **C"₆.**

Thus, the secondary chamfer 75 of the support 7 is always situated facing the flat zone 67 of the substrate 6 and forms a small angle β relative thereto. Bonding between these two faces is improved and a larger fraction of the useful layer 63 is transferred onto the chamfer 75. Consequently, the area of the useful layer 63 that is actually transferred increases, and conversely the area of the ring decreases.

Finally, and advantageously, the source substrate 6 is bonded to the support substrate 7 in such a manner that the flat central zone 70 of the support 7 is centered relative to the central zone 67 of the source substrate 6. Thus, the useful layer 63 as transferred is also centered or substantially centered relative to the support 7.

A second implementation of the invention is described below with reference to Figure 6.

This embodiment is the opposite of the embodiment described with reference to Figure 5, i.e. the source substrate 6 has a flat central zone 60, a primary chamfer 64, and a secondary chamfer 65, while the front face 700 of the support substrate 7 is constituted by a flat zone 77 surrounded by a peripheral side face 76 extending perpendicularly or substantially perpendicularly.

As above, the dimensions of the outline **C"₇** of the flat zone 77 of the support 7 are greater than the dimensions of the outer outline **C₆** of the flat central zone 60 of the source substrate 6, and during bonding, the source substrate 6 is applied against the support substrate 7 in such a manner that this outline **C₆** is inscribed within the outline **C"₇.**

Also preferably, the dimensions of the outline **C"₇** are greater than the dimensions of the inner outline **C'₆** of the primary chamfer 64 of the source substrate 6, and during bonding the source substrate 6 is applied against the support substrate 7 in such a manner that the inner outline **C'₆** is inscribed inside said outline **C"₇.**

Advantageously, the substrates 6 and 7 are also centered relative to each other.

Of the two implementations described above, the implementation of Figure 5 in which the source substrate 6 presents an edge 66 perpendicular to the flat surface 67 is generally preferred for reasons associated with implementing the method on an industrial scale.

Whatever the implementation selected for the substrates 6 and 7, the useful layer 63 can be removed from the source substrate 6 in a variety of manners which are now described.

In a first variation, prior to the step of molecular bonding substrates 6 and 7 to each other, a zone of weakness 62 is formed within the source substrate 6 to define and delimit the useful layer 63 subsequently transferred to the support 7. After bonding, said useful layer 63 is detached from the remainder of the source substrate 6 along this zone of weakness 62.

It should be observed that Figures 4 to 6 are merely diagrammatic and, for clarification purposes, the useful layer 63 is shown therein as being much thicker than it is in reality.

Techniques for forming said zone of weakness 62 are known to the skilled person and are not all described in detail.

Advantageously, this zone of weakness 62 is formed by implanting atomic species from the front face 600.

The term "implanting atomic species" means any bombardment of atomic, molecular or ionic species, which can introduce said species into a material with a maximum concentration of said species located at a predetermined depth from the bombarded surface 600. The molecular or ionic atomic species are introduced into the material with an energy that is also distributed about a maximum.

Atomic species can be implanted into said source substrate 6 using an ion beam implanter or a plasma immersion implanter, for example.

Preferably, implantation is carried out by ionic bombardment. Preferably, the implanted ionic species is hydrogen. Other ionic species can advantageously be used alone or in combination with hydrogen, such as rare gases (for example helium).

Implantation creates the zone of weakness 62 within the bulk of the source substrate 6 and at a mean ion penetration depth, the zone being substantially parallel to the plane of the front face 600. The useful layer 63 extends from the front face 600 to this zone of weakness 62.

Reference should be made, for example to the literature concerning the method known by its registered trade mark "Smart Cut".

The zone of weakness 62 can also be constituted by a porous layer obtained, for example, using the method known by its registered trade mark "ELTRAN" from Canon, described in European patent EP-A-0 849 788.

After the step of molecular bonding the faces 600 and 700, the useful layer 63 is detached from the remainder of the source substrate 6.

Detachment of the useful layer 63 is performed subsequently by at least one of the following techniques alone or in combination: applying constraints of mechanical origin (inserting a blade or a jet of fluid under pressure into the zone of weakness 62) or of electrical origin, supplying heat energy, and chemical etching. These detachment techniques are known to the skilled person and they are not described in greater detail. This provides a composite substrate having a useful layer 63 transferred onto a support 7.

As mentioned above, the useful layer 63 is detached horizontally, along the zone of weakness 62 and also by means of "vertical self-limitation" vertically in register with the zone where bonding to the support is of sufficient strength.

Finally, in a third variation of the implementation not shown in figures, it is also possible to produce the useful layer 63 by the technique known as "bond and etchback" in which, after bonding the front face 600 of the source substrate 6 onto the front face 700 of the support substrate 7, the rear face of said source substrate 6 undergoes treatment by lapping and/or etching by chemical attack, and then polishing, until only the thickness corresponding to said useful layer 63 remains on the support 7.

In the particular case of SOI (silicon on insulator) substrates, it is possible to obtain the useful layer 63 by the BESOI method mentioned in the introduction of this application.

Finally, examples of materials to which said method can be applied are given.

The support substrate 7 is formed from a material that is optionally a semiconductor and that is selected, for example, from: silicon; a transparent substrate (such as quartz or glass, for example); silicon carbide; gallium arsenide; indium phosphide; or germanium.

Preferably, the source substrate 6 is formed from a semiconductor material selected, for example, from: silicon; germanium; silicon carbide; silicon and germanium alloys or "compounds" (known as Si-Ge compounds); or alloys or compounds known as III/V compounds, i.e., compounds one element of which is from column IIIa of the periodic table and the other is from column Va, such as gallium nitride; gallium arsenide; or indium phosphide.

Finally, it should be noted that it is possible to cover the front face 700 of the support 7 with an insulating layer of the oxide type (for example SiO₂) or of the nitride type (for example Si₃N₄), this insulating layer then being interposed between the useful layer 63 and said support 7, after detaching said layer 63.

It is possible to cover the front face 600 of the source substrate 6 with an insulating material of the type mentioned above, the transferred useful layer 63 then comprising two layers. It is even possible to deposit a plurality of layers onto the source substrate 6 and the term "useful layer" then designates a stack of layers.

## Claims

1. A method of increasing the area of a useful layer (63) of a material, in particular a semiconductor material, transferred onto a support substrate (7), during the fabrication of a composite substrate in particular for applications in the fields of electronics, optics, or optoelectronics, the method comprising at least one step of molecular bonding a "front" face (600) of a source substrate (6) to a facing "front" face (700) of a support substrate (7), and a step of transferring a useful layer (63) coming from said source substrate (6) onto said support substrate (7), said useful layer (63) extending inside said source substrate (6) from its front face (600), one of said support and source substrates (7 and 6) to be bonded together, referred to as the "first" substrate (7, 6), being surrounded by a primary chamfer (74, 64) and presenting on its front face (700, 600) a flat central zone (70, 60) and a secondary chamfer (75, 65) extending between said flat central zone (70, 60) and said primary chamfer (74, 64), the method being **characterized in that** the other substrate, referred to as the "second" substrate (6, 7), is a bulk substrate the front face (600, 700) of which presents a flat zone (67, 77) bordered by a peripheral side face (66, 76), perpendicular or quasi-perpendicular thereto, the outer outline (**C"₆,C"**₇) of said flat zone (67, 77) presenting dimensions greater than the dimensions of the outer outline (**C₇,C₆**) of the flat central zone (70, 60) of the first substrate (7, 6), and **in that** during bonding, the two substrates (6, 7) are applied one against the other in such a manner that the outline (**C₇ ,C₆**) of the flat central zone (70, 60) of the first substrate (7, 6) is inscribed within the outline (**C"₆,C"₇**) of the flat zone (67, 77) of the second substrate (6, 7).

2. A method according to claim 1, **characterized in that** the dimensions of the outer outline (**C"₆, C"₇**) of the flat zone (67, 77) of the second substrate (6, 7) are greater than the dimensions of the inner outline (**C'₇, C'₆**) of the primary chamfer (74, 64) of the first substrate (7, 6), and **in that** during bonding, the substrates are applied one against the other in such a manner that the inner outline (**C'₇, C'₆**) of the primary chamfer (74, 64) of the first substrate (7, 6) is inscribed inside the outer outline (**C"₆, C"₇**) of the flat zone (67, 77) of the second substrate (6, 7).

3. A method according to any preceding claim, **characterized in that** the first substrate (7, 6) is bonded to the second substrate (6, 7) in such a manner that its flat central zone (70, 60) is centered relative to the flat zone (67, 77) of said second substrate (6, 7).

4. A method according to any preceding claim, **characterized in that** the second substrate is the source substrate (6).

5. A method according to any preceding claim, **characterized in that** prior to the step of bonding the source substrate (6) and the support substrate (7) against each other, the method consists in forming a zone of weakness (62) inside said source substrate (6), said useful layer (63) to be transferred extending between said zone of weakness (62) and the front face (600) of said substrate (6), and after the bonding step, the method consists in detaching said useful layer (63) from the remainder of the source substrate (6) along said zone of weakness (62).

6. A method according to claim 5, **characterized in that** said zone of weakness (62) is formed by atomic species implantation.

7. A method according to claim 5, **characterized in that** said zone of weakness (62) is formed by a porous layer.

8. A method according to claim 5, **characterized in that** the useful layer (63) is detached by at least one of the following techniques taken alone or in combination: applying stresses of mechanical or electrical origin; supplying thermal energy; and chemical etching.

9. A method according to any preceding claim, **characterized in that** at least one of the faces selected from the front face (600) of the source substrate (6) and the front face (700) of the support substrate (7) is coated in a layer of an insulating material.

## Patentansprüche

1. Verfahren zum Vergrößern der Fläche einer Nutzschicht (63) eines Materials, insbesondere eines Halbleitermaterials, das auf ein Trägersubstrat (7) übertragen wird, während der Herstellung eines zusammengesetzten Substrats, insbesondere für Anwendungen in den Bereichen Elektronik, Optik oder Optoelektronik, wobei das Verfahren umfasst wenigstens einen Schritt eines molekularen Verbindens einer "Vorderseite" (600) eines Ausgangssubstrats (6) mit einer gegenüberliegenden "Vorderseite" (700) eines Trägersubstrats (7) und einen Schritt eines Übertragens einer Nutzschicht (63), die von dem Ausgangssubstrat (6) auf das Trägersubstrat (7) kommt, wobei sich die Nutzschicht (63) innerhalb des Ausgangssubstrats (6) von seiner Vorderseite (600) erstreckt, wobei eines des Träger- und des Ausgangssubstrats (7, 6), die verbunden werden sollen, das als erstes Substrat (7, 6) bezeichnet wird, von einer Primärabschrägung (74, 64) umgeben ist und auf seiner Vorderseite (700, 600) eine flache Zentralzone (70, 60) und eine Sekundärabschrägung (75, 65) aufweist, die sich zwischen der flachen Zentralzone (700, 600) und der Primärabschrägung (74, 64) erstreckt, **dadurch gekennzeichnet, dass** das andere Substrat, das als "zweites" Substrat (6, 7) bezeichnet wird, ein massives Substrat ist, dessen Vorderseite (600, 700) eine flache Zone (67, 77) aufweist, die von einer Umfangsseitenfläche (66, 76) begrenzt ist, die rechtwinklig oder quasi rechtwinklig dazu ist, wobei die äußere Kontur (C"₆, C"₇) der flachen Zone (67, 77) Abmessungen aufweist, die größer sind als die Abmessungen der äußeren Kontur (C₇, C₆) der flachen Zentralzone (70, 60) des ersten Substrats (7, 6) und **dadurch**, dass die zwei Substrate (6, 7) während eines Verbindens so gegeneinander gelegt werden, dass die Kontur (C₇, C₆) der flachen Zentralzone (70, 60) des erstens Substrats (7, 6) in die Kontur (C"₆, C"₇) der flachen Zone (67, 77) des zweiten Substrats (6, 7) einbeschrieben ist.

2. Verfahren nach Anspruch 1, **dadurch gekennzeichnet, dass** die Abmessungen der äußeren Kontur (C"₆, C"₇) der flachen Zone (67, 77) des zweiten Substrats (6, 7) größer sind als die Abmessungen der inneren Kontur (C'₇, C'₆) der Primärabschrägung (74, 64) des ersten Substrats (7, 6), und **dadurch**, dass die Substrate während des Verbindens so gegeneinander gelegt werden, dass die innere Kontur (C'₇, C'₆) der Primärabschrägung (74, 64) des ersten Substrats (7, 6) in die äußere Kontur (C"₆, C"₇) der flachen Zone (67, 77) des zweiten Substrats (6, 7) einbeschrieben ist.

3. Verfahren nach einem der vorstehenden Ansprüche, **dadurch gekennzeichnet, dass** das erste Substrat (7, 6) mit dem zweiten Substrat (6, 7) derart verbunden ist, dass seine flache Zentralzone (70, 60) bezüglich der flachen Zone (67, 77) des zweiten Substrats (6, 7) zentriert ist.

4. Verfahren nach einem der vorstehenden Ansprüche, **dadurch gekennzeichnet, dass** das zweite Substrat das Ausgangssubstrat (6) ist.

5. Verfahren nach einem der vorstehenden Ansprüche, **dadurch gekennzeichnet, dass** das Verfahren vor dem miteinander Verbinden des Ausgangssubstrats (6) und des Trägersubstrats (7) darin besteht, eine Schwachstelle (62) innerhalb des Ausgangssubstrats (6) zu bilden, wobei sich die Nutzschicht (63), die übertragen werden soll, zwischen der Schwachstelle (62) und der Vorderseite (600) des Substrats (6) erstreckt, und das Verfahren nach dem Verbindungsschritt im Lösen der Nutzschicht (63) vom Rest des Ausgangssubstrats (6) entlang der Schwachstelle (62) besteht.

6. Verfahren nach Anspruch 5, **dadurch gekennzeichnet, dass** die Schwachstelle (62) durch Implantation atomarer Elemente gebildet wird.

7. Verfahren nach Anspruch 5, **dadurch gekennzeichnet, dass** die Schwachstelle (62) durch eine poröse Schicht gebildet wird.

8. Verfahren nach Anspruch 5, **dadurch gekennzeichnet, dass** die Nutzschicht (63) durch wenigstens eine der folgenden Techniken allein oder in Kombination gelöst wird:
Anwenden von Belastungen mechanischen oder elektrischen Ursprungs;
Anlegen thermischer Energie; und chemisches Ätzen.

9. Verfahren nach einem der vorstehenden Ansprüche, **dadurch gekennzeichnet, dass** wenigstens eine der Seiten, die aus der Vorderseite (600) des Ausgangssubstrats (6) und der Vorderseite (700) des Trägersubstrats (7) ausgewählt ist, mit einer Schicht eines Isolatormaterials beschichtet ist.

## Revendications

1. Procédé d'augmentation de l'aire d'une couche utile (63) d'un matériau, notamment semiconducteur, reportée sur un substrat support (7), au cours de la fabrication d'un substrat composite notamment pour des applications dans les domaines de l'électronique, l'optique ou l'opto-électronique, ce procédé comprenant au moins une étape de collage par adhésion moléculaire d'une face "avant" (600) d'un substrat source (6), sur la face "avant" en regard (700) d'un substrat support (7), et une étape de report d'une couche utile (63) provenant dudit substrat source (6), sur ledit substrat support (7), ladite couche utile (63) s'étendant à l'intérieur dudit substrat source (6) depuis la face avant (600) de celui-ci, l'un desdits substrats support et source (7 et 6) à coller ensemble, dit "premier substrat" (7, 6), étant bordé par un chanfrein primaire (74, 64) et présentant sur sa face avant (700, 600), une zone centrale plane (70, 60) et un second chanfrein (75, 65) s'étendant entre ladite zone centrale plane (70, 60) et ledit chanfrein primaire (74, 64), le procédé étant **caractérisé en ce que** l'autre substrat, dit "second" substrat (6, 7), est un substrat massif dont la face avant (600, 700) présente une zone plane (67, 77), bordée par un chant latéral périphérique (66, 76) qui lui est perpendiculaire ou quasiment perpendiculaire, le contour extérieur (**C"₆, C"₇**) de cette zone plane (67, 77) présentant des dimensions supérieures aux dimensions du contour extérieur (**C₇, C₆**) de la zone centrale plane (70, 60) du premier substrat (7, 6) et **en ce que** lors du collage, les deux substrats (6, 7) sont appliqués l'un contre l'autre de façon que le contour (**C₇, C₆**) de la zone centrale plane (70, 60) du premier substrat (7, 6) soit inscrit à l'intérieur du contour (**C"₆ ; C"₇**) de la zone plane (67, 77) du second substrat (6, 7).

2. Procédé selon la revendication 1, **caractérisé en ce que** les dimensions du contour extérieur (**C"₆, C"₇**) de la zone plane (67, 77) du second substrat (6, 7) sont supérieures aux dimensions du contour intérieur (**C'₇, C'₆**) du chanfrein primaire (74, 64) du premier substrat (7, 6) et **en ce que** lors du collage, les substrats sont appliqués l'un contre l'autre de façon que le contour intérieur (**C'₇, C'₆**) du chanfrein primaire (74, 64) du premier substrat (7,6) soit inscrit à l'intérieur du contour extérieur (**C"₆, C"₇**) de la zone plane (67, 77) du second substrat (6,7).

3. Procédé selon l'une quelconque des revendications précédentes, **caractérisé en ce que** le premier substrat (7, 6) est collé sur le second substrat (6, 7), de façon que sa zone centrale plane (70, 60) soit centrée par rapport à la zone plane (67, 77) dudit second substrat (6,7).

4. Procédé selon l'une quelconque des revendications précédentes, **caractérisé en ce que** le second substrat est le substrat source (6).

5. Procédé selon l'une quelconque des revendications précédentes, **caractérisé en ce qu'**il consiste avant l'étape de collage du substrat source (6) et du substrat support (7) l'un contre l'autre, à former une zone de fragilisation (62) à l'intérieur dudit substrat source (6), ladite couche utile (63) à reporter s'étendant entre cette zone de fragilisation (62) et la face avant (600) dudit substrat (6) et après l'étape de collage, à effectuer le détachement de ladite couche utile (63) du reste du substrat source (6), le long de cette zone de fragilisation (62).

6. Procédé selon la revendication 5, **caractérisé en ce que** ladite zone de fragilisation (62) est formée par implantation d'espèces atomiques.

7. Procédé selon la revendication 5, **caractérisé en ce que** ladite zone de fragilisation (62) est formée d'une couche poreuse.

8. Procédé selon la revendication 5, **caractérisé en ce que** le détachement de la couche utile (63) est effectué par au moins l'une des techniques suivantes prises seules ou en combinaison parmi l'application de contraintes d'origine mécanique ou électrique, l'apport d'énergie thermique et la gravure chimique.

9. Procédé selon l'une quelconque des revendications précédentes, **caractérisé en ce qu'**au moins l'une des faces entre la face avant (600) du substrat source (6) et la face avant (700) du substrat support (7) est recouverte d'une couche d'un matériau isolant.
